(19) Europäisches Patentamt
European Patent Office
Office européen des brevets

(11) **EP 1 788 642 B1**

(12) **EUROPEAN PATENT SPECIFICATION**

(45) Date of publication and mention
of the grant of the patent:
**06.10.2010 Bulletin 2010/40**

(51) Int Cl.:
*H01L 39/24* (2006.01)

(21) Application number: **06124206.1**

(22) Date of filing: **16.11.2006**

(54) **Nb3Sn superconducting wire and precursor for the same**

Nb3Sn supraleitender Draht und Vorläuferzusammensetzung dafür

Fil supraconducteur à base de Nb3Sn et matériau précurseur pour celui-ci

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **18.11.2005 JP 2005334716**

(43) Date of publication of application:
**23.05.2007 Bulletin 2007/21**

(73) Proprietors:
• **Japan Superconductor Technology Inc.
Kitakyushu-shi
Fukuoka 800-0007 (JP)**
• **Kabushiki Kaisha Kobe Seiko Sho (Kobe Steel,
Ltd.)
Kobe-shi,
Hyogo 651-8585 (JP)**

(72) Inventors:
• **Hase, Takashi
Moji-ku, Kitakyushu-shi Hyogo 800-0007 (JP)**
• **Murakami, Yukinobu
Moji-ku, Kitakyushu-shi Fukuoka 800-0007 (JP)**
• **Yasunaka, Hiroyuki
Moji-ku ,Kitakyushu-shi Fukuoka 800-0007 (JP)**
• **Miyazaki, Takayoshi
Kobe-shi Hyogo 651-2271 (JP)**
• **Kato, Hiroyuki
Kobe-shi Hyogo 651-2271 (JP)**
• **Zaitsu, Kyoji
Kobe-shi Hyogo 651-2271 (JP)**

(74) Representative: **TBK-Patent
Bavariaring 4-6
80336 München (DE)**

(56) References cited:
**JP-A- 2004 035 940    JP-A- 2004 192 972**

**Description**

BACKGROUND OF THE INVENTION

1. Field of the Invention

The present invention relates to a $Nb_3Sn$ superconducting wire formed by the bronze method and a precursor for the same (a precursor for manufacturing of a $Nb_3Sn$ superconducting wire), and more particularly, to a $Nb_3Sn$ superconducting wire serving as a material of a superconducting magnet of the type chilled by means of liquid helium immersion, a superconducting magnet of the type chilled with a cooling machine and the like, i.e., typically magnets for use in high-resolution nuclear magnetic resonance (NMR) analyzers and also to a precursor for manufacturing of such superconducting wires.

2. Description of the Related Art

Development is ongoing on a superconducting magnet in which a coil of a winding superconducting wire carries a large current and a strong magnetic field accordingly develops, aiming at application to a fusion device, etc., besides nuclear magnetic resonance (NMR) analyzers, various types of physical property evaluators and the like. Of these, NMR analyzers are the only apparatuses with which it is possible to analyze the molecular structures of biological polymers, proteins and the like which can not be crystallized, and as such, serve as a powerful tool to promote post-genome development. In addition, since the stronger the magnetic field superconducting magnet develops, the better the resolution of the analyzer becomes, the higher the ratio of an NMR signal to noises becomes and the shorter analysis becomes. As the material of such a superconducting magnet, a $Nb_3Sn$ superconducting wire has been widely used as a representative material.

While various methods are already known to form the $Nb_3Sn$ superconducting wire described above, the most typical method is the bronze method

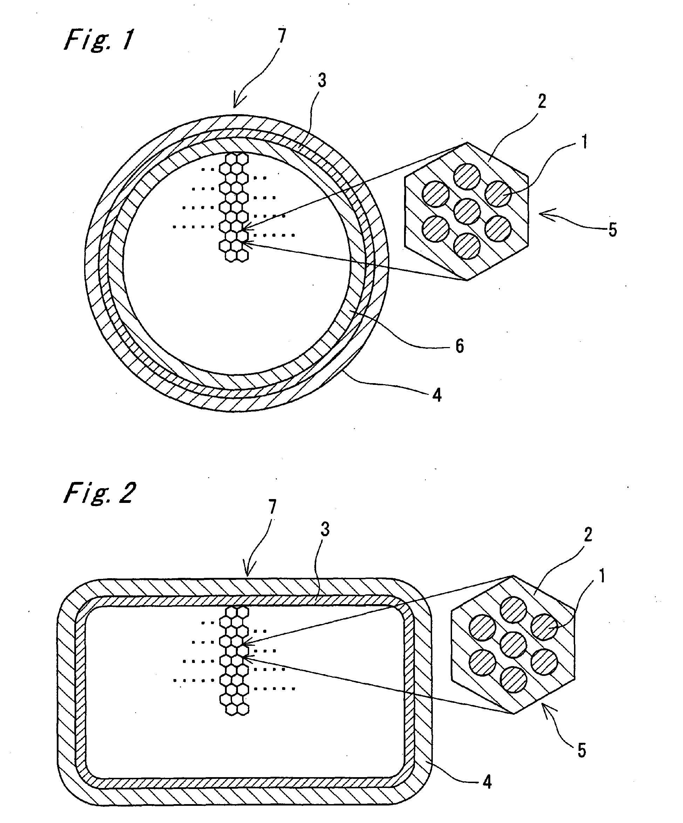

Fig. 1 is a schematic explanatory diagram for describing the cross-sectional structure of a $Nb_3Sn$ superconducting wire manufactured by the bronze method, and in Fig. 1, denoted at 1 is a Nb or Nb alloy core, denoted at 2 is a wire-shaped Cu-Sn-based alloy base material (bronze matrix), denoted at 3 is a diffusion barrier layer, denoted at 4 is stabilization copper, denoted at 5 is a primary stack member (precursor for manufacturing the $Nb_3Sn$ superconducting wire), denoted at 6 is an outer layer case and denoted at 7 is a secondary multi-core billet.

First, as shown in Fig. 1, plural (seven in Fig. 1) Nb or Nb alloy cores 1 are buried in the Cu-Sn-based alloy base material 2, thereby obtaining the primary stack member 5 (precursor for manufacturing the $Nb_3Sn$ superconducting wire) shaped to have a hexagonal cross-sectional shape, and plural such primary stack members 5 are bundled and inserted inside a pipe-shaped Cu-Sn alloy (outer layer case 6) around which a Nb sheet or a Ta sheet is wound as the diffusion barrier layer 3 or a Nb or Ta sheet is wound directly around the bundle of the primary stack members, and the stabilization copper 4 is disposed further outside this, whereby the secondary multi-core billet 7 is assembled. The diffusion barrier layer 3 has a function of suppressing diffusion of Sn to outside during heat treatment which aims at creation of $Nb_3Sn$. The stabilization copper 4 is disposed as a stabilizer for the $Nb_3Sn$ superconducting wire, and may be made for instance of oxygen free copper.

The secondary multi-core billet 7 shown in Fig. 1 is hydrostatically extruded and thereafter area-reduced by a drawing process or the like, thereby obtaining a multi-core precursor for manufacturing the $Nb_3Sn$ superconducting wire. This is followed by heat treatment (diffusion heat treatment) for about 100 hours approximately at 650 through 720 degrees Celsius, so that a $Nb_3Sn$ phase is created in the vicinity of the Nb or Nb alloy cores 1 (i.e., at the interface between the Cu-Sn based alloy base material 2 and the Nb or Nb alloy cores 1 in this example).

While the stabilization copper 4 is disposed as the outer-most layer of the secondary multi-core billet 7 in the structure described above, in relation to the location of the stabilization copper 4, a structure that the stabilization copper 4 is disposed in a central section (center-of-axis section) of the secondary multi-core billet 7 may be used instead. In addition, although the cross-sectional shape of the secondary multi-core billet 7 is circular in the structure shown in Fig. 1, the cross-sectional shape of the secondary multi-core billet 7 may be rectangular (rectangular shaped wire) as shown in Fig. 2 for example.

By the way, for manufacturing of a $Nb_3Sn$ superconducting wire by the bronze method, the higher the Sn content in the bronze matrix is, the higher the critical current density Jc in a high magnetic field becomes, which is advantageous in realizing a superconducting magnet generating a stronger magnetic field. However, since the solid solubility limit of Sn in an $\alpha$ phase of the Cu-Sn-based alloy is 15.8 mass%, a higher Sn content beyond this results in Cu-Sn intermetallic compounds (typically, a "$\delta$ phase"). This value of solid solubility limit however, is a value at a high temperature of 520 through 586 degrees Celsius: during an actual manufacturing of a bronze ingot, the solid solubility limit is about 15.6 mass% due to cooling.

The δ phase is harder and less ductile than the α phase, which causes a crack in the wire during area reduction processing. While addition of a third element such as Ti to the Cu-Sn-based alloy base material is known as an approach to increase the upper critical current value of $Nb_3Sn$, this will rarely change the solid solubility limit of Sn.

As a solution to the workability problem of the δ phase, another method has been proposed which requires repeating cold working and annealing in a condition that the processing rate of cold working/area reduction processing and the annealing temperature are determined and accordingly processing the created δ phase while dividing the δ phase into small pieces (See the claims and the other relevant sections of JPB 3108496, for instance.). However, as this method leaves the δ phase in small pieces rather than eliminating the same, as the wire is thinned, the ratio of the diameter of the Cu-Sn intermetallic compounds to the diameter of the wire increases and cracking becomes probable.

Another technique has been proposed which requires disposing pure copper, which is excellent in workability, around a precursor in which Nb or Nb alloy cores are buried inside a bronze matrix, to thereby avoid problems such as a crack and a break (See the claims and the other relevant sections of JPA H08-96633, for example). This technique however, demanding use of pure copper free from Sn, gives rise to a problem that the total Sn content becomes too low as compared with where the entire part is made of bronze having a high Sn content and that superconducting properties become insufficient.

Yet another technique has been proposed which requires using a relatively high Sn content and a predetermined Ti content to thereby attain a great extrusion ratio at a high temperature (See the claims and the other relevant sections of JPB 1515094, for instance.). However, this technique does not consider the δ phase, and according even to the preferred embodiments, the Sn content is up to the solid solubility limit described above.

Another prior art example is found in JP 2004035940.

Even if the workability problems above are solved and a wire is obtained satisfactorily through working, it is nevertheless difficult to meet in a simple manner the specifications regarding superconducting properties (the critical current density Jc and the n-value) which a wire for use as a magnet of an NMR analyzer is expected to exhibit. For example, the tendency is that if Nb or Nb alloy cores (which are sometimes called "Nb filaments") after area reduction processing are thinned, the n-value will become small although the critical current density Jc will become large, whereas if the Nb filaments are formed thick, the critical current density Jc will become small although the n-value will become large. It is thus necessary to improve the Sn content in bronze while optimizing the cross-sectional structure of the wire. The n-value is an amount which is indicative of the sharpness of a transition from the superconducting state to the normal conducting state, and it is said that the larger the n-value is, the better the properties are.

These problems described above have so far prevented realization of a $Nb_3Sn$ superconducting wire produced by the bronze method exhibiting superconducting properties which are practically satisfactory at the temperature of liquid helium of 4.2 K in an extremely strong magnetic field of 20 T (teslas) or higher.

SUMMARY OF THE INVENTION

The present invention has been made in light of such a circumstance, and accordingly, an object of the present invention is to provide a precursor for manufacturing a $Nb_3Sn$ superconducting wire whose workability remains excellent despite use of bronze having a high Sn content and which will not create the δ phase whose diameter exceeds the diameter of Nb filaments and to provide a $Nb_3Sn$ superconducting wire which exhibits superconducting properties being practically satisfactory in a strong magnetic field owing to a multi-core precursor in which the cross-sectional structure of the wire is optimized as needed.

The precursor for manufacturing a $Nb_3Sn$ superconducting wire according to the present invention which achieves the object above is a precursor for manufacturing a $Nb_3Sn$ superconducting wire in which plural Nb or Nb-based alloy cores are buried in a Cu-Sn-based alloy base material, wherein the Cu-Sn-based alloy base material contains Ti and/or Zr in addition to Sn, and these components satisfy the equations (1) and (2) below:

$$0.4 \leq (X - 15.6) / Y \leq 1.9 \qquad (1)$$

$$15.6 < X \leq 19 \qquad (2)$$

where the symbol X denotes the content of Sn in mass% and the symbol Y denotes the total content of Ti and Zr in mass%.

In such a precursor for manufacturing a $Nb_3Sn$ superconducting wire according to the present invention, the Nb-based alloy cores preferably contain Ta and/or Hf in the total amount of 0.1 through 5.0 mass%.

According to the invention it is possible to realize a multi-core precursor for manufacturing a $Nb_3Sn$ supercon-

ducting wire which is formed by bundling such plural precursors for manufacturing a Nb$_3$Sn superconducting wire and then area-reducing the same, wherein a ratio Bz, which is a ratio of the cross section area of the Cu-Sn-based alloy to the total cross section area of the Nb or Nb-based alloy cores, and an average diameter Df in $\mu$m of the Nb or Nb-based alloy cores satisfy the equations (3) and (4) below:

$$2\ Bz\ \leqq\ Df\ \leqq\ 4\ Bz \qquad\qquad ...\ (3)$$

$$1.8\ \leqq\ Bz\ \leqq\ 3.0 \qquad\qquad ...\ (4)$$

As the multi-core precursor for manufacturing a Nb$_3$Sn superconducting wire described above is heat treated, the Nb$_3$Sn phase is created at the interface between the Cu-Sn-based alloy base material and the Nb or Nb-based alloy cores, which in turns forms a Nb$_3$Sn superconducting wire exhibiting excellent superconducting properties (the critical current density Jc and the n-value).

According to the present invention, as a predetermined amount of Ti or Zr is added to the Cu-Sn-based alloy which forms the precursor, thereby making it possible to manufacture a Nb$_3$Sn superconducting wire in which a matrix is made of a bronze alloy which suppresses creation of the $\delta$ phase despite a high Sn content beyond the solid solubility limit, and hence, obtain a capability represented by superconducting properties which are necessary in a stronger magnetic field than before. This permits realization of an NMR magnet or the like at 960 MHz or higher for instance which has never been available, and therefore, detailed analysis of molecular structures of biological polymers and proteins.

BRIEF DESCRIPTION OF THE DRAWINGS

Fig. 1 is an explanatory diagram which schematically shows one example of the cross-sectional structure of a Nb$_3$Sn superconducting wire manufactured by the bronze method;

Fig. 2 is an explanatory diagram which schematically shows other example of the cross-sectional structure of a Nb$_3$Sn superconducting wire manufactured by the bronze method;

Fig. 3 is a graph which shows the influence of an Sn content X and a total content Y of Ti and Zr over the morphology of compounds;

Fig. 4 is a graph which shows the influence of a relationship between a bronze ratio Bz and an average diameter Df of Nb filaments over the critical current density nonCu-Jc; and

Fig. 5 is a graph which shows the influence of the relationship between the bronze ratio Bz and the average diameter Df of Nb filaments over the n-value.

DETAILED DESCRIPTION OF THE PREFERRED EMBODIMENTS

The inventors of the present invention conducted studies from various perspectives to solve the problems described above. The result is the findings that addition of a third element, which may be Ti and/or Zr, to a Cu-Sn-based alloy eliminates the $\delta$ phase itself in the Cu-Sn-based alloy. It then follows that the $\delta$ phase will not be created even if more Sn than what has been heretofore considered as the solid solubility limit, namely, 15.6 mass% is contained in a Cu-Sn-based alloy. Although an Sn content over 15.6 mass% creates Sn which can not be dissolved in the $\alpha$ phase, this Sn will precipitate as Cu-Sn-Ti or Cu-Sn-Zr. These precipitates however, as long as the content of the third element (Ti and/or Zr) is appropriate, are as small as 2 $\mu$m or less and smaller than the diameter of Nb filaments, and therefore, do not influence the workability of the wire as a whole.

In contrast, before area reduction processing, the $\delta$ phase described above is 10 $\mu$m or larger even when smallest, and even though the $\delta$ phase can be reduced in cross section through area reduction processing, the $\delta$ phase has already been drawn along the drawing direction and therefore remains not much changed in terms of overall size from how it was before area reduction processing. Further, Cu-Sn-Ti and Cu-Sn-Zr get decomposed during diffusion heat treatment which creates the Nb$_3$Sn phase and Sn created at this stage is predicted to contribute to growth of the Nb$_3$Sn phase, which means that every single Sn in the bronze matrix could react with the Nb filaments.

When the content of Ti or Zr is too small, the $\delta$ phase precipitates within the bronze matrix and adversely affects the workability of the wire as a whole, whereas an excessive content creates more Cu-Sn-Ti and Cu-Sn-Zr and adversely affects the workability of the wire by the same token. It is therefore necessary to control the content of Ti or Zr in the Cu-Sn-based alloy to an appropriate range.

The inventors of the present invention studied an optimal relationship between the total content Y (mass%) of Ti and Zr and the Sn content X (mass%) in the Cu-Sn-based alloy. The result is the findings that it is possible to prevent precipitation of the $\delta$ phase within a range which satisfies $0.4 \leqq (X - 15.6) / Y \leqq 1.9$ [the equation (1) described earlier] and $15.6 < X \leqq 19$ [the equation (2) described earlier] and the range is proper to secure creation of Cu-Sn-Ti and Cu-Sn-Zr in very fine sizes, thereby completing the present invention. Further, when these relationships are satisfied, the sizes of Cu-Sn-(Ti, Zr) contained in a Cu-Sn-based alloy ingot are suppressed down to 10 $\mu$m or less and the workability becomes excellent so that it is possible to execute processing without constrained by the extrusion ratio, the drawing temperature, etc., like where JPB 1515094 above is exercised. The preferable range as for the equation (1) above is $0.6 \leqq (X - 15.6) / Y \leqq 1.0$.

With respect to superconducting properties, while the critical current density Jc increases as the Nb$_3$Sn phase is created in an increasingly larger area, if the Nb filaments all transform to the Nb$_3$Sn phase, the n-value tends to decrease. On the contrary, when the Nb$_3$Sn phase is created in a narrow area, the n-value becomes large although the critical current density Jc becomes low. Considering this, it is believed that the both values will become large if an appropriate amount of unreacted Nb filaments is left.

Although the size of an area where the Nb$_3$Sn phase is created tends to expand as the heat treatment time becomes long, since heat treatment even beyond 100 hours will not greatly change in reality the size of an area where the Nb$_3$Sn phase is created, a standard heat treatment time is thought to be approximately 100 through 150 hours.

The inventors of the present invention clarified that assuming such a standard heat treatment time, as long as the ratio (hereinafter referred to as the "bronze ratio Bz") of the cross section area of the Cu-Sn-based alloy (bronze matrix, including the outer case 6) to the total cross section area of the Nb or Nb-based alloy cores (namely, the Nb filaments) in the multi-core precursor and the average diameter Df of the Nb filaments satisfy the equations (3) and (4) above, both the critical current density Jc and the n-value of the heat treated Nb$_3$Sn superconducting wire become large.

This bronze ratio is a ratio found on the final wire diameter of the multi-core precursor, but has a similar value to that of the bronze ratio measured on the primary stack members, irrespective of the processing rate of area reduction processing. Further, the area reduction processing rate at this stage is expressed by the equation below, and is preferably within the range of 99.90 to 99.99 % approximately: The processing rate = ((the cross section area of the secondary multi-core billet) - (the cross section area of the wire having the final wire diameter)) / (the cross section area of the secondary multi-core billet).

The Nb-based alloy cores used in the precursor for manufacturing a superconducting wire according to the present invention may be pure Nb containing Ta and/or Hf, which further improves the superconducting properties (the critical current density Jc, in particular). Where these elements are added however, it is preferable to properly adjust their contents. When Ta and/or Hf is added to Nb, the tensile strength and the hardness at a room temperature become superior to those of pure Nb. Further, while area reduction processing after extrusion is conducted at a room temperature, the Cu-Sn-based alloy is generally harder than pure Nb during area reduction processing, and since the Cu-Sn-based alloy causes work hardening during area reduction processing, the difference in terms of hardness between the two expands. If the materials of a complex are significantly different in hardness, healthy processing will be difficult. Addition of Ta and/or Hf to pure Nb at the content of approximately 0.1 through 5.0 mass% properly improves the hardness and reduces the hardness difference from the Cu-Sn-based alloy, which makes it possible to perform processing to obtain a uniform cross sectional surface along the longitudinal direction. As a result, the n-value as well further improves. In the event that the total content of Ta, and Hf is less than 0.1 mass%, the hardness is almost no different from that of pure Nb, whereas the content beyond 5.0 mass% deteriorates the workability of the Nb-based alloy itself and makes well-conditioned processing difficult.

While the primary stack members satisfying the conditions above are bundled to form the multi-core precursor according to the present invention, it is not always necessary for all primary stack members to be bundled to satisfy the requirements [relations of the above equations (1) and (2)]: even when some fail to satisfy these requirements, the structure including the primary stack members may be completed such that the structure as a whole will meet the requirements. That is, even when some primary stack members do not satisfy the equations (1) and (2) above as they have some variations with respect to the Sn content, the content of Ti, Zr and etc., the object of the present invention is achieved as long as the composition of the multi-core precursor as a whole satisfies the equations (1) and (2) above.

While the present invention will now be described in more details with reference to examples, the examples below do not in any sense limit the present invention and any design changes in line with the purposes described earlier and below fall under the technical scope of the present invention. For example, although Figs. 1 and 2 show the primary stack members shaped hexagonal in cross section, the cross sectional shape may be circular or any other shapes. Further, the present invention is applicable also to a structure that the stabilization copper is disposed in a central section (center-of-axis section).

Comparative Example 1

A Cu-Sn-based alloy whose composition was Cu-16mass%Sn-0.15mass%Ti[(X-15.6)/Y=2.7] was melted and casted, which was followed by solution treatment in the atmosphere which aimed at homogenization under the condition of 680 degrees Celsius $\times$ 100 hours + 600 degrees Celsius $\times$ 100 hours. The composition of the Cu-Sn-based alloy was confirmed by the inductively-coupled plasma spectroscopy (ICP). Through microscopic observation and analysis using an electron microscope and X-ray micro-analysis, it was confirmed that Cu-Sn compounds (the $\delta$ phase) of about 100-$\mu$m were present.

Using this Cu-Sn-based alloy and pure Nb, primary stack members (See Figs. 1 and 2.) having the bronze ratio of 2.2 were manufactured. A Nb sheet (the diffusion barrier layer 3 described earlier) was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and finally, by drawing using a rectangular die, a rectangular wire having a cross sectional structure as that shown in Fig. 2 described above (multi-core precursor for manufacturing a Nb$_3$Sn superconducting wire) was obtained (which had the total degree of processing of 99.98 %). The cross sectional surface size of this wire as 1.40 $\times$ 2.30 mm$^2$ (the average diameter Df of the Nb filaments = 6.0 $\mu$m). The bronze ratio Bz was 2.2. During processing for obtaining a wire having the final length of 2500 m in total, breaking occurred five times in total. Electron microscopic observation of the breaking sections revealed that the breaks started at Cu-Sn compounds (the $\delta$ phase). The bronze ratio Bz and the average diameter Df of the Nb filaments in the multi-core precursor were confirmed on electron microscope photographs.

Comparative Example 2

A Cu-Sn-based alloy whose composition was Cu-16mass%Sn-2.0mass%Ti[(X-15.6)/Y=0.20] was melteded and casted, which was followed by solution treatment in the atmosphere which aimed at homogenization under the condition of 680 degrees Celsius $\times$ 100 hours + 600 degrees Celsius $\times$ 100 hours. The composition of the Cu-Sn-based alloy was confirmed by the inductively-coupled plasma spectroscopy (ICP). Through microscopic observation and analysis using an electron microscope and X-ray micro-analysis, it was confirmed that Cu-Sn compounds (the 5 phase) have disappeared.

Using this Cu-Sn-based alloy and pure Nb, primary stack members (See Figs. 1 and 2.) having the bronze ratio of 2.2 were manufactured. A Nb sheet was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and finally, by drawing using a rectangular die, a rectangular wire having a cross sectional structure as that shown in Fig. 2 described above (multi-core precursor for manufacturing a Nb$_3$Sn superconducting wire) was obtained (which had the total degree of processing of 99.98 %). The cross sectional surface size of this wire was 1.40 $\times$ 2.30 mm$^2$ (the average diameter Df of the Nb filaments = 6.0 $\mu$m). The bronze ratio Bz was 2.2.

Breaking never occurred. Microscopic observation and analysis using an electron microscope and X-ray micro-analysis confirmed the existence of Cu-Sn-Ti compounds in which the average diameter Df of the Nb filaments was 6.0 $\mu$m or larger, and clarified that these compounds precipitated distorting the Nb filaments in some regions.

After thus manufactured multi-core precursor was heat treated at 720 degrees Celsius for 100 hours, the critical current density nonCu-Jc (= the critical current / the cross sectional surface size exclusive of the stabilization copper) and the n-value (expressing the gradient of a generated voltage and an electric current logarithmically plotted relative to each other) were evaluated at the temperature of 4.2K in an external magnetic field of 20T, and it was found that the n-value was 21 which was below the criterion of 30 or larger which needs be met for use although nonCu-Jc was 135 A/mm$^2$ which was a greater value than the criterion of 130 A/mm$^2$ which needs be met for use as a high magnetic field NMR wire. The bronze ratio Bz and the average diameter Df of the Nb filaments in the multi-core precursor were confirmed on electron microscope photographs.

Example 1

A Cu-Sn-based alloy whose composition was Cu-16mass%Sn-0.5mass%Ti[(X-15.6)/Y=0.80] was melted and casted, which was followed by solution treatment in the atmosphere which aimed at homogenization under the condition of 680 degrees Celsius $\times$ 100 hours + 600 degrees Celsius $\times$ 100 hours. The composition of the Cu-Sn-based alloy was confirmed by the inductively-coupled plasma spectroscopy (ICP). Through micro observation analysis using an electron microscope and X-ray micro-analysis, it was confirmed that Cu-Sn compounds (the $\delta$ phase) have disappeared.

Using this Cu-Sn-based alloy and pure Nb, primary stack members (See Figs. 1 and 2.) having the bronze ratio of 2.2 were manufactured. A Nb sheet was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and finally, by drawing using a rectangular die, a rectangular wire having a cross sectional structure as that shown in Fig. 2 described above (multi-core precursor for manufacturing a $Nb_3Sn$ superconducting wire) was obtained. The cross sectional surface size of this wire was $1.40 \times 2.30$ mm$^2$ (the average diameter Df of the Nb filaments = 6.0 $\mu$m).

Breaking never occurred. Through microscopic observation and analysis using an electron microscope and X-ray micro-analysis, it was not confirmed the existence of Cu-Sn-Ti compounds in which the average diameter Df of the Nb filaments was 6.0 $\mu$m or larger.

After thus manufactured multi-core precursor was heat treated at 720 degrees Celsius for 100 hours, the critical current density nonCu-Jc and the n-value in the non-copper section were evaluated at the temperature of 4.2K in an external magnetic field of 20T, and it was found that nonCu-Jc was as large as 148 A/mm$^2$ and the n-value was as large as 35 both of which satisfied the criteria which need be met for use as a high magnetic field NMR wire. The bronze ratio Bz and the average diameter Df of the Nb filaments in the multi-core precursor were confirmed on electron microscope photographs and computed.

Example 2

Cu-Sn-based alloys having different compositions which were obtained by adding Ti and Zr to Cu-Sn-based alloys were melted and casted into ingots which were then processed by solution treatment for homogenization under the same condition as that for Example 1. The compositions of the Cu-Sn-based alloys were confirmed by the inductively-coupled plasma spectroscopy (ICP). Through microscopic observation and analysis using an electron microscope and X-ray micro-analysis, whether the ingots contained Cu-Sn compounds (the $\delta$ phase) was examined. Following this, using thus obtained ingots and pure Nb, primary stack members having the bronze ratio of 2.2 were manufactured, hydrostatically extruded and area-reduced as in Example 1, thereby manufacturing rectangular wire (multi-core precursors for manufacturing $Nb_3Sn$ superconducting wire) having cross sectional structures as that of the rectangular wire fabricated in Example 1 (the total processing rate: 99.98 %). The bronze ratios Bz and the average diameters Df of the Nb filaments in the multi-core precursors were confirmed on electron microscope photographs.

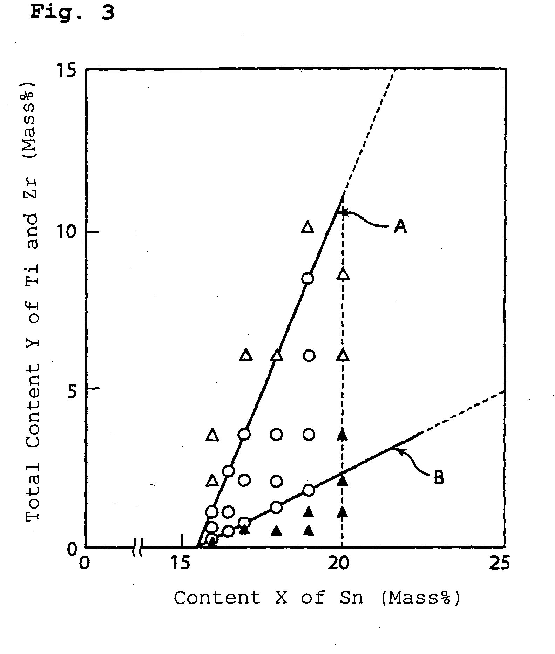

Through microscopic observation and analysis using an electron microscope and X-ray micro-analysis, the sizes of Cu-Sn-(Ti, Zr) were measured and their relationship with the compositions was investigated. Fig. 3 shows the result (i.e., the influence of the Sn content X and the total content Y of Ti and Zr over the morphology of the compounds). In Fig. 3, the symbol ▲ denotes those compositions which created Cu-Sn compounds (the $\delta$ phase) in the ingots processed by solution treatment, the symbol △ denotes those compositions which resulted in creation of Cu-Sn-(Ti, Zr) compounds of 6.0 $\mu$m or larger after processing the ingots into the wire, and the symbol ○ denotes those compositions which did not create Cu-Sn compounds (the $\delta$ phase) in the ingots which were processed by solution treatment and even after processing the ingots into the wire, did not result in creation of Cu-Sn-(Ti, Zr) of 6.0 $\mu$m or larger. The line A expresses the relationship $Y = (X - 15.6) / 0.4$, while the line B expresses the relationship $Y = (X - 15.6) / 1.9$. From this result, one can see that those satisfying the equations (1) and (2) described earlier (namely, those denoted at the symbol ○) achieved excellent control of the morphology of the compounds.

Example 3

A Cu-Sn-based alloy whose composition was Cu-16mass%Sn-0.5mass%Ti[(X-15.6)/Y=0.80] was melted and casted, and then processed by solution treatment for homogenization under the same condition as that for Example 1. The composition of the Cu-Sn-based alloy was confirmed by the inductively-coupled plasma spectroscopy (ICP). Using this Cu-Sn-based alloy, primary stack members having the bronze ratio ranging from 1.4 to 3.4 were manufactured, a Nb sheet (the diffusion barrier layer 3 described earlier) was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and its final cross sectional surface size was adjusted so that the average diameters Df of the Nb filaments would be 3.0 through 11.0 $\mu$m, whereby a rectangular wire having a cross sectional structure as that shown in Fig. 2 described above (multi-core precursor for manufacturing a $Nb_3Sn$ superconducting wire) was obtained (which had the total processing rate of 99.98 %). The bronze ratio Bz and the average diameter Df of the Nb filaments in the multi-core precursor were confirmed on electron microscope photographs.

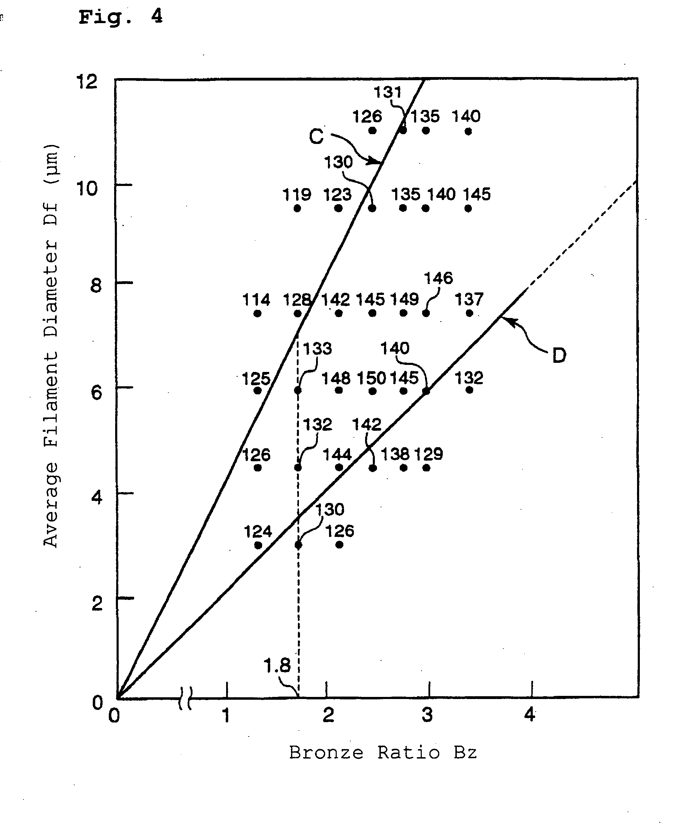

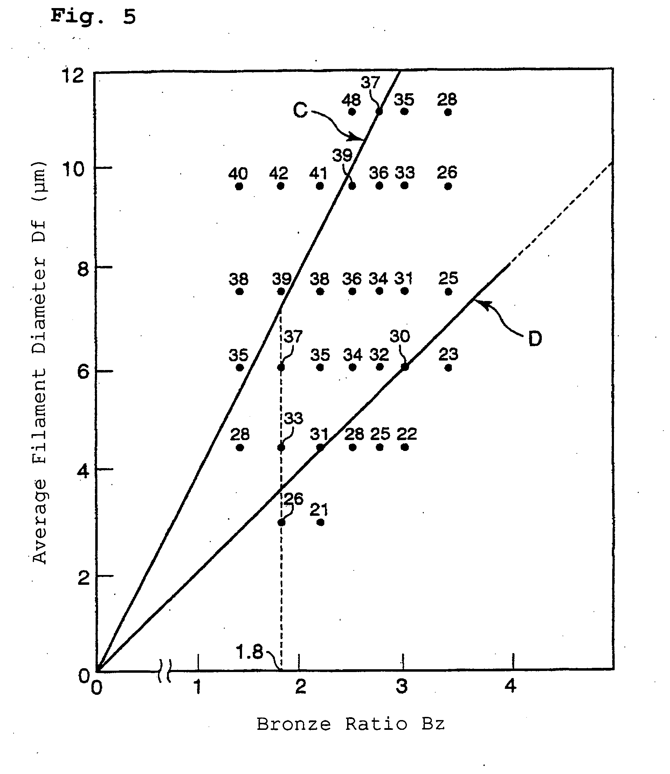

After thus manufactured multi-core precursor was heat treated at 720 degrees Celsius for 100 hours, the critical current density nonCu-Jc and the n-value in the non-copper section were evaluated at the temperature of 4.2K in an external magnetic field of 20T. Figs. 4 and 5 show the result. Fig. 4 shows the influence of a relationship between the bronze ratio Bz and the average diameter Df of Nb filaments over the critical current density nonCu-Jc, and Fig. 5 shows the influence of the relationship between the bronze ratio Bz and the average diameter Df of Nb filaments over the n-value. The numerical values in Fig. 4 are the values of the critical current (in A/mm$^2$), while the numerical values in Fig. 5 are the n-values. The lines C in Figs. 4 and 5 denote Df = 4 Bz, and the lines D denote Df = 2 Bz.

As is clear from this result, within ranges satisfying the equations (3) and (4) described earlier, the criteria regarding the critical current density nonCu-Jc and the n-value which need be met for use as a high magnetic field NMR wire are met. It was also confirmed that use of Zr instead of Ti in a Cu-Sn-based alloy achieved a similar result.

Example 4

A Cu-Sn-based alloy whose composition was Cu-16mass%Sn-0.5mass%Ti[(X-15.6)/Y=0.80] as that manufactured in Example 1 was melted and casted, and then processed by solution treatment for homogenization under the same condition as that for Example 1. The composition of the Cu-Sn-based alloy was confirmed by the inductively-coupled plasma spectroscopy (ICP). Using this Cu-Sn-based alloy and Nb-3.0mass%Ta, primary stack members (See Figs. 1 and 2.) having the bronze ratio of 2.2 were manufactured. A Nb sheet was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and finally, by drawing using a rectangular die, a rectangular wire having a cross sectional structure as that shown in Fig. 2 described above (multi-core precursor for manufacturing a Nb$_3$Sn superconducting wire) was obtained (which had the total processing rate of 99.98 %). The cross sectional surface size of this wire was 1.40 × 2.30 mm$^2$ (the average diameter Df of the Nb filaments = 6.0 μm). The bronze ratio Bz was 2.2. The bronze ratio Bz and the average diameter Df of the Nb filaments in the multi-core precursor were confirmed on electron microscope photographs.

Breaking never occurred. Microscopic observation and analysis using an electron microscope and X-ray micro-analysis did not confirm the existence of Cu-Sn-Ti compounds in which the average diameter Df of the Nb filaments was 6.0 μm or larger.

After thus manufactured multi-core precursor was heat treated at 720 degrees Celsius for 100 hours, the critical current density nonCu-Jc and the n-value in the non-copper section were evaluated at the temperature of 4.2K in an external magnetic field of 20T, and it was found that nonCu-Jc was as large as 145 A/mm$^2$ and the n-value was as large as 42 both of which satisfied the criteria which need be met for use as a high magnetic field NMR wire.

Although the primary stack members had the same size in the examples described above, it is also possible to form a multi-core precursor even when primary stack members having different sizes are used or when some primary stack members made of a Cu-Sn-based alloy in which no Nb or Nb-based alloy is buried are used: as long as the bronze ratio Bz measured on a multi-core precursor as it is before heat treated satisfies the equations (3) and (4) described earlier, a similar effect to that obtained where primary stack members having the same size and the same form are used is expected.

Example 5

Using a Cu-Sn-based alloy as it was after solution treatment whose composition was Cu-17.0mass%Sn-0.8mass%Ti[(X-15.6)/Y=1.75] and using pure Nb, primary stack members (See Figs. 1 and 2.) having the bronze ratio of 2.2 were manufactured. A Nb sheet was wound directly around a bundle of approximately 4000 such primary stack members, and the resulting structure was inserted into a pipe of oxygen free copper, thereby putting together a secondary multi-core billet. This secondary multi-core billet was hydrostatically extruded and then area-reduced by means of repeated drawing and annealing, and finally, by drawing using a rectangular die, a rectangular wire having a cross sectional structure as that shown in Fig. 2 described above (multi-core precursor for manufacturing a Nb$_3$Sn superconducting wire) was obtained. The cross sectional surface size of this wire was 1.40 × 2.30 mm$^2$ (the average diameter Df of the Nb filaments = 6.0 μm). The composition of the Cu-Sn-based alloy was confirmed by the inductively-coupled plasma spectroscopy (ICP). The bronze ratio Bz and the average diameter Df of the Nb filaments in the multi-core precursor were confirmed on electron microscope photographs. Breaking never occurred. Microscopic observation and analysis using an electron microscope and X-ray micro-analysis did not confirm the existence of Cu-Sn-Ti compounds in which the average diameter Df of the Nb filaments was 6.0 μm or larger.

After thus manufactured multi-core precursor was heat treated at 720 degrees Celsius for 100 hours, the critical current density nonCu-Jc and the n-value in the non-copper section were evaluated at the temperature of 4.2K in an external magnetic field of 20T, and it was found that nonCu-Jc was as large as 145 A/mm$^2$ and the n-value was as large as 35 both of which satisfied the criteria which need be met for use as a high magnetic field NMR wire.

As for the bronze ratio Bz and the average diameter Df of the Nb filaments of a wire using this Cu-Sn-based alloy, a region satisfying the criteria which need be met for use as a high magnetic field NMR wire was investigated, and an equivalent result to that shown in Figs. 4 and 5 was attained which showed that 2 Bz ≦ Df ≦ 4 Bz and 1.8 ≦ Bz ≦ 3.0 were appropriate ranges.

Although the heat treatment for creation of $Nb_3Sn$ was conducted over one stage of 720 degrees Celsius for 100 hours in Example 1 through Example 5 described above, it was found that even better nonCu-Jc than that achieved through one-stage heat treatment was obtained through two-stage heat treatment of 600 through 670 degrees Celsius for 50 through 200 hours followed by 680 through 750 degrees Celsius for 50 through 150 hours.

The bronze ratio Bz and the average diameter Df of the Nb filaments were confirmed with an electron microscope in the following manner. First, as for the bronze ratio Bz, a microscope photograph of regions where there were at least 19 primary stack members were subjected to image processing, and the area ratios of the primary stack members to the Cu-Sn-based alloys and those to the diameters of the Nb filaments were calculated. As for the average diameter Df of the Nb filaments, on the microscope photographs showing such regions where there were at least 19 primary stack members, the largest diameters of the Nb filaments were summed up and then divided by the number of these Nb filaments.

The composition of the Cu-Sn-based alloy of the wire was identified in the following manner by the inductively-coupled plasma spectroscopy (ICP). First, the wire was cut into the length of several tens of mm and the stabilization copper section was removed with nitric acid, the wire sample was then heated up to 200 through 300 degrees Celsius in a mixture of hydrochloric acid, nitric acid and water, thereby dissolving all of the Cu-Sn-based alloy portion except for Nb, and thereafter heated with addition of sulfuric acid so that undissolved oxides as well were dissolved and a sample solution was thus prepared. This sample solution was subjected to plasma emission, and the composition of the solution was identified from a spectrum.

During observation of Cu-Sn-Ti and the like using an electron microscope and X-ray micro-analysis, while observing reflection electron images with the electron microscope (Different compositions show as a varying contrast.), an electron beam accelerated to 10 through 30 keV was irradiated upon areas where different precipitations than the Cu-Sn-based alloy and the Nb cores were found, and the composition of Cu-Sn-Ti and the like was identified from a spectrum obtained with the emitted characteristic X-ray.

## Claims

1. A multi-core precursor for manufacturing a $Nb_3Sn$ superconducting wire formed by bundling and then area-reducing plural precursors comprising one or more precursors for manufacturing a $Nb_3Sn$ superconducting wire by bronze method,

   wherein said precursor for manufacturing a $Nb_3Sn$ superconducting wire by bronze method comprises plural Nb or Nb-based alloy cores buried in a Cu-Sn-based alloy base material;

   wherein said Cu-Sn-based alloy base material comprises Ti and/or Zr in addition to Sn, and these components satisfy the equations (1) and (2) below:

$$0.4 \leq (X - 15.6) / Y \leq 1.9 \quad (1)$$

   and

$$15.6 < X \leq 19 \quad (2)$$

   where the symbol X denotes the content of Sn in mass% and the symbol Y denotes the total content of Ti and Zr in mass%; and

   wherein a ratio Bz, which is a ratio of the cross section area of said Cu-Sn-based alloy to the total cross section area of said Nb or Nb-based alloy cores, and an average diameter Df in $\mu$m of said Nb or Nb-based alloy cores satisfy the equations (3) and (4) below:

$$2\ Bz \leq Df \leq 4\ Bz \quad (3)$$

   and

$$1.8 \leq Bz \leq 3.0 \qquad (4).$$

**2.** A multi-core precursor for manufacturing a $Nb_3Sn$ superconducting wire according to claim 1, wherein said Nb-based alloy cores comprise Ta and/or Hf in the total amount of 0.1 through 5.0 mass%.

**3.** A $Nb_3Sn$ superconducting wire in which the multi-core precursor according to claim 1 is heat treated, thereby creating a $Nb_3Sn$ phase at the interface between said Cu-Sn-based alloy base material and said Nb or Nb-based alloy cores.

**4.** A $Nb_3Sn$ superconducting wire in which the multi-core precursor according to claim 2 is heat treated, thereby creating a $Nb_3Sn$ phase at the interface between said Cu-Sn-based alloy base material and said Nb or Nb-based alloy cores.

**Patentansprüche**

**1.** Mehrkernvorläufer zum Herstellen eines $Nb_3Sn$ supraleitfähigen Drahtes gebildet durch Bündeln und dann Flächenreduzieren mehrerer Vorläufer, umfassend einen oder mehrere Vorläufer zum Herstellen eines $Nb_3Sn$ supraleitfähigen Drahtes durch ein Bronzeverfahren,
wobei der Vorläufer zum Herstellen eines $Nb_3Sn$ supraleitfähigen Drahtes durch ein Bronzeverfahren mehrere in ein Cu-Sn-basiertes Legierungsgrundmaterial eingebettete Nb- oder Nb-basierte Legierungs-Kerne umfasst;
wobei das Cu-Sn-basierte Legierungsgrundmaterial Ti und/oder Zr zusätzlich zu Sn umfasst, und diese Bestandteile die Gleichungen (1) und (2) erfüllen:

$$0.4 \leq (X - 15.6) / Y \leq 1.9 \qquad (1)$$

und

$$15.6 < X \leq 19 \qquad (2)$$

wobei das Symbol X den Gehalt an Sn in Massen-% bezeichnet und das Symbol Y den Gesamtgehalt an Ti und Zr in Massen-% bezeichnet; und
wobei ein Verhältnis Bz, welches ein Verhältnis der Querschnittsfläche der Cu-Sn-basierten Legierung zu der gesamten Querschnittsfläche der Nb- oder Nb-basierte Legierungs-Kerne ist, und ein durchschnittlicher Durchmesser Df in $\mu$m der Nb- oder Nb-basierten Legierungs-Kerne die Gleichungen (3) und (4) erfüllen:

$$2 Bz \leq Df \leq 4 Bz \qquad (3)$$

und

$$1.8 \leq Bz \leq 3.0 \qquad (4).$$

**2.** Mehrkernvorläufer zum Herstellen eines $Nb_3Sn$ supraleitfähigen Drahtes nach Anspruch 1, wobei die Nb-basierten Legierungs-Kerne Ta und/oder Hf in der Gesamtmenge von 0,1 bis 5,0 Massen-% umfassen.

**3.** $Nb_3Sn$ supraleitfähiger Draht, bei welchem der Mehrkernvorläufer nach Anspruch 1 wärmebehandelt ist, wodurch eine $Nb_3Sn$-Phase an der Grenzfläche zwischen dem Cu-Sn-basierten Legierungsgrundmaterial und den Nb- oder Nb-basierten Legierungs-Kernen erzeugt ist.

**4.** $Nb_3Sn$ supraleitfähiger Draht, bei welchem der Mehrkernvorläufer nach Anspruch 2 wärmebehandelt ist, wodurch eine $Nb_3Sn$-Phase an der Grenzfläche zwischen dem Cu-Sn-basierten Legierungsgrundmaterial und den Nb- oder Nb-basierten Legierungskernen erzeugt ist.

**Revendications**

1. Précurseur à âmes multiples pour la fabrication d'un fil supraconducteur de Nb$_3$Sn formé par la mise en faisceau puis par la réduction de section de précurseurs multiples comprenant un ou plusieurs précurseurs pour la fabrication d'un fil supraconducteur de Nb$_3$Sn par le procédé au bronze,
   dans lequel ledit précurseur pour la fabrication d'un fil supraconducteur de Nb$_3$Sn par le procédé au bronze comprend des âmes multiples de Nb ou d'un alliage à base de Nb noyées dans un matériau de base d'un alliage à base de Cu-Sn ;
   dans lequel ledit matériau de base d'un alliage à base de Cu-Sn comprend du Ti et/ou du Zr en plus du Sn, et ces composants satisfont aux équations (1) et (2) ci-dessous :

$$0,4 \leq (X - 15,6) \ / \ Y \leq 1,9 \quad (1)$$

et

$$15,6 < X \leq 19 \quad\quad (2)$$

où le symbole X dénote la teneur en Sn en % en masse et le symbole Y dénote la teneur totale en Ti et Zr en % en masse ; et
   dans lequel un rapport Bz, qui est un rapport de la superficie en coupe dudit alliage à base de Cu-Sn sur la superficie en coupe totale desdites âmes de Nb ou d'un alliage à base de Nb, et un diamètre moyen Df en μm desdites âmes de Nb ou d'un alliage à base de Nb satisfont aux équations (3) et (4) ci-dessous :

$$2 \ Bz \leq Df \leq 4 \ Bz \quad (3)$$

et

$$1,8 \leq Bz \leq 3,0 \quad (4).$$

2. Précurseur à âmes multiples pour la fabrication d'un fil supraconducteur de Nb$_3$Sn selon la revendication 1, dans lequel lesdites âmes d'un alliage à base de Nb comprennent du Ta et/ou du Hf dans la quantité totale de 0,1 jusqu'à 5,0% en masse.

3. Fil supraconducteur de Nb$_3$Sn dans lequel le précurseur à âmes multiples selon la revendication 1 est traité à la chaleur, créant ainsi une phase Nb$_3$Sn à l'interface entre ledit matériau de base d'un alliage à base de Cu-Sn et lesdites âmes de Nb ou d'un alliage à base de Nb.

4. Fil supraconducteur de Nb$_3$Sn dans lequel le précurseur à âmes multiples selon la revendication 2 est traité à la chaleur, créant ainsi une phase Nb$_3$Sn à l'interface entre ledit matériau de base d'un alliage à base de Cu-Sn et lesdites âmes de Nb ou d'un alliage à base de Nb.

*Fig. 1*

*Fig. 2*

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

* JP 2004035940 B